# EUROPEAN PATENT SPECIFICATION

(11) **EP 0 233 333 B1**
(45) Date of publication and mention of the grant of the patent: **10.02.1993**
(21) Application number: 86116308.7
(22) Date of filing: 25.11.1986
(51) Int. Cl.: G03F 7/26

(54) **Method of treating photoresists**
Photolack-Behandlungsverfahren
Procédé de traitement de photoréserves

(30) Priority: 14.02.1986 JP 28774/86
(43) Date of publication of application: 26.08.1987
(73) Proprietor: USHIO DENKI, Tokyo, 100 (JP)
(72) Inventor: Tanaka, Kazuya, Yokohama-shi Kanagawa (JP); Ueki, Kazuyoshi, Yokohama-shi Kanagawa (JP); Suzuki, Hiroko, Yokohama-shi Kanagawa (JP); Mimura, Yoshiki, Yokohama-shi Kanagawa (JP); Suzuki, Shinji, Yokohama-shi Kanagawa (JP); Sugioka, Shinji, Yokohama-shi Kanagawa (JP)
(74) Representative: Lang, Friedrich, Dipl.-Ing.

(56) References cited:
- GB-A- 2 143 961
- MICROELECTRONIC ENGINEERING, vol. 3, no. 1/4, December 1985, pages 329-337, Elsevier Science Publishers B.V., North-Holland, Amsterdam, NL; A. GUTMANN et al.: "Thermal stability and etching resistance of formaldehyde- and deep UV-hardened photoresists"
- SOLID STATE TECHNOLOGY, vol. 27, no. 7, July 1984, pages 45-46, Port Washington, New York, US; "Photoresist stabilization system"
- IBM TECHNICAL DISCLOSURE BULLETIN, vol. 26, no. 2, July 1983, pages 656-657, New York, US; F. MARTINET: "Control of resist-hardening process in a barrel plasma etcher system"
- JOURNAL OF THE ELECTROCHEMICAL SOCIETY, vol. 29, no. 6, June 1982, pages 1379-1382, Princeton, New Jersey, US; R. ALLEN et al.: "Deep U.V. hardening of positive photoresist patterns"

## Description

This invention relates to a method of treating photoresist materials applied on semiconductor wafer and, more particularly, to a method of treating the photoresist materials employing ultraviolet irradiation.

As for the prior-art treatment of a photoresist employing ultraviolet irradiation, exposing the photoresist to ultraviolet radiation is utilized in a treatment in which a mask pattern is formed by exposing the photoresist applied on a semiconductor water, in a preliminary cleansing treatment in which organic pollutants sticking on the surface of the semiconductor wafers are dissolved and cleansed away, etc., and recently attention has been paid to the application of this method to particular treatments of photoresists such as baking photoresist materials.

The baking process is an intermediate between a process of forming a photoresist pattern by applying, exposing and developing the photoresist and a process of executing ion implantation, plasma etching, etc. by using the photoresist pattern, and it is a heating process executed for improving the adhesiveness of the photoresist to a semiconductor substrate, heat resistance, etc. Studies have been made recently on a method in which ultraviolet rays are applied to the photoresist before or during the baking process after development so as to enhance the heat resistance and plasma resistance of the photoresist through the baking process in a shorter time.

GB-A 2 143 961 discloses a method for hardening a photoresist, in which the photoresist is subjected to elevated temperatures during the UV radiation. The photoresist temperature is controlled in such a manner that it is always below the flow temperature which increases during exposure.

When a light having a high ultraviolet intensity is applied to the photoresist at the beginning of exposure, however, organic solvent included in the photoresist is decomposed and evaporated, or photochemical reactions take place in the photoresist itself or agents which are applied to a wafer as preliminary treatment for the application of the photoresist, and then a gas is generated from the photoresist, and this gas causes deformation or breakdown of a photoresist film.

An object of this invention is to provide a method enabling effective treatment of the photoresist employing ultraviolet irradiation by preventing the deformation of the photoresist which is caused by exposing it to high ultraviolet radiation at the beginning of exposure.

The photoresist is exposed to ultraviolet radiation of low intensity at the beginning of exposure, and then exposed to ultraviolet radiation,the intensity of which increases little by little or in steps.

In this way, the aforementioned gas is generated slowly from the photoresist and released little by little in the air. Moreover, the intensity of ultraviolet radiation increases little by little or in steps after the generation of the gas stops substantially. Accordingly, the time required for the photoresist treatment is shortened, and effective treatment of the photoresist, in which the deformation of the photoresist is not caused by ultraviolet irradiation,is accomplished.

Other objects and advantages of this invention will become apparent from the following description of the preferred form of the invention which is illustrated in the drawings accompanying and forming part of this specification.

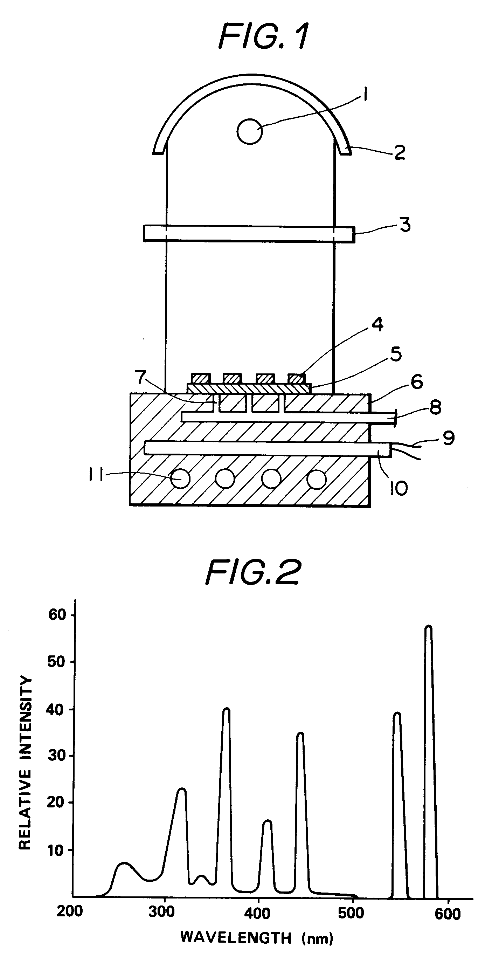

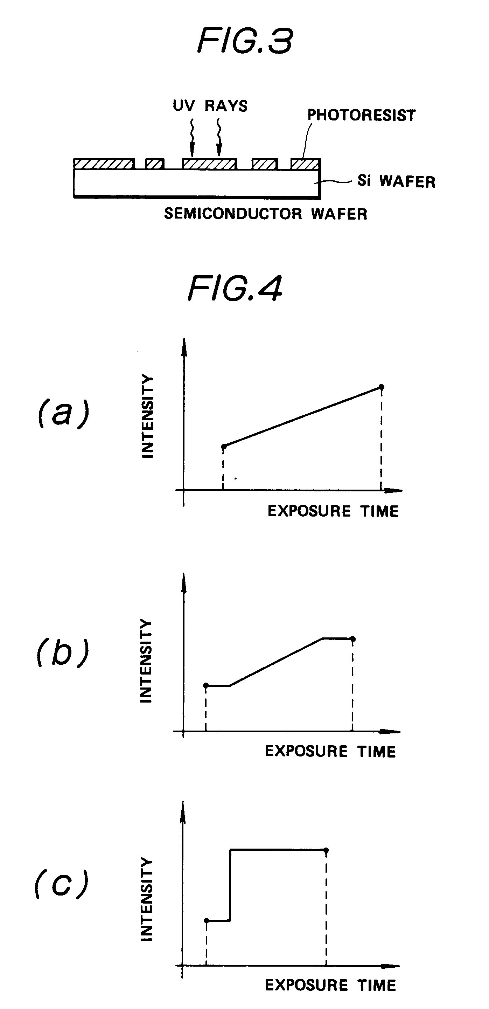

Fig. 1 shows an apparatus of treating a photoresist for explaining one embodiment of a method of treating a photoresist according to this invention. Fig. 2 shows a radiation spectrum of a high pressure mercury vapor lamp employed to execute the method of treating a photoresist according to the invention. Fig. 3 shows a semiconductor wafer, on which a photoresist is applied. Fig. 4 shows charts of the intensity of ultraviolet irradiation for exposure time.

This invention will be described concretely hereinafter on the basis of embodiments shown in drawings.

Figure 1 shows an embodiment of an apparatus of treating a photoresist for explaining one embodiment of a method for treatments of photoresists according to this invention.

A pattern of a photoresist 4 is formed on a semiconductor wafer 5, which is placed on a support 6. The support 6 is heated by a heater 10 connected with power supply through a heater lead wire 9,or cooled down by cooling water to flow through a cooling conduit 11. The temperature of the semiconductor wafer 5 is controlled by these heating and cooling mechanisms. Moreover, the support 6 is provided with vacuum adsorption holes 7, a function of which is to fix the semiconductor wafer 5 on the support 6 in close contact with it by the vacuum adsorption connected with a vacuum pump through a connecting conduit 8. A part of ultraviolet irradiation is composed of a high pressure mercury vapor lamp 1, a concave mirror 2 and a shutter 3 which can be opened and closed, etc.

A figure of an electric circuit for lighting the high pressure mercury vapor lamp 1 is omitted. The intensity of ultraviolet radiation is altered by changing the electric circuit constant. As to the electric circuit for lighting the high pressure mercury vapor lamp 1, publicly known and publicly used one, which is disclosed in published documents, is available.

Figure 2 shows the radiation spectrum of the high pressure mercury vapor lamp. Figure 4 shows one example of chart of the intensity of ultraviolet irradiation which increases little by little or in steps by changing the electric circuit constant of the electric circuit for lighting the high pressure mercury vapor lamp. This figure is an orthogonal coordinate system with relative intensity of ultraviolet irradiation as vertical axis and exposure time as lateral axis. Figure 4(a), 4(b), 4(c) show changes of the intensity of ultraviolet irradiation, which increases little by little for all exposure time, increases little by little for intermediate exposure time and steps up in steps, respectively. The following is a more concrete description as to figure 4(c). A positive type photoresist which was formed of novolak resin, etc. was applied to the radiant light having a wavelength below 350 nm. The intensity of this irradiated light was 100mW/cm² for 10 seconds from the beginning of exposure, and 500mW/cm² for 30 seconds to 40 seconds thereafter. In this case, deformation of the photoresist pattern, formation of bubbles and deformation of the photoresist film were not caused, and effective treatment of the photoresist was enabled. But, when the intensity of the irradiated light was 500mW/cm² from the beginning of the exposure to the end, formation of bubbles, deformation the photoresist film,etc. occurred in parts.

In the above-mentioned embodiment, the intensity of the light irradiated on the photoresist is controlled by changing the intensity of the light radiated from the high pressure mercury vapor lamp. The means of controlling the intensity of the light irradiated on the photoresist is not limited thereto. Means of controlling the intensity of the light irradiated on the photoresist by employing a light source which maintains a uniform intensity of radiant light and means of decreasing ultraviolet irradiation such as filter which is prepared between high pressure mercury vapor lamp and wafer may be used as well.

## Claims

1. A method of enhancing the thermal stability of a developed photoresist pattern on a semiconductor wafer which is capable of generating a gas upon exposure to ultraviolet radiation, comprising the steps of:
exposing the photoresist pattern to ultraviolet radiation of an intensity sufficiently low as to generate and release said gas at the beginning of the exposure, without formation of bubbles, deformation of the photoresist pattern or deformation of the photoresist film, and
then increasing the intensity of said ultraviolet radiation while continuing to expose said photoresist pattern to said ultraviolet radiation without deformation by said gas generated and released at said beginning of exposure.

## Patentansprüche

1. Verfahren zur Erhöhung der Wärmebeständigkeit eines entwickelten Fotolackmusters auf einem Halbleiter-Wafer, welches in der Lage ist, ein Gas zu erzeugen, wenn es ultravioletter Strahlung ausgesetzt wird, wobei das Verfahren folgende Schritte aufweist:
das Fotolackmuster wird einer ultravioletten Strahlung ausgesetzt, die eine Intensität aufweist, die ausreichend niedrig ist, um zu Beginn des Aussetzens das Gas zu erzeugen und freizugeben, ohne daß Blasen gebildet werden, das Fotolackmuster deformiert wird oder der Fotolackfilm deformiert wird, und
anschließend wird die Intensität der Ultraviolettstrahlung verstärkt, während das Fotolackmuster weiterhin der ultravioletten Strahlung ausgesetzt wird, ohne daß eine Deformation durch das am Beginn des Aussetzens erzeugte und freigegebene Gas erfolgt.

## Revendications

1. Un procédé de renforcement de la stabilité thermique d'un motif de photoréserves developpé sur une pastille semi-conductrice qui est capable de générer un gaz lors d'une exposition à un rayonnement ultraviolet, comprenant les opérations consistant à :
exposer le motif de photoréserves à un rayonnement ultraviolet d'une intensité suffisamment basse pour générer et libérer ledit gaz au début de l'exposition, sans formation de bulles, déformation du motif de photo-réserves, ni déformation de la pellicule de photoréserves, et
augmenter ensuite l'intensité dudit rayonnement ultraviolet tout en continuant d'exposer ledit motif de photoréserves audit rayonnement ultraviolet sans déformation par ledit gaz généré et libéré audit début de l'exposition.
